# EUROPÄISCHE PATENTSCHRIFT

(11) **EP 1 857 815 B1**
(45) Veröffentlichungstag und Bekanntmachung des Hinweises auf die Patenterteilung: **09.04.2014**
(21) Anmeldenummer: 06716855.9
(22) Anmeldetag: 01.02.2006
(51) Int. Cl.: G01N 27/83, G01V 3/10

(54) **VERFAHREN UND VORRICHTUNG ZUR DETEKTION VERSTECKTER SUBSTANZEN**
METHOD AND DEVICE FOR DETECTING HIDDEN SUBSTANCES
PROCEDE ET DISPOSITIF DE DETECTION DE SUBSTANCES CACHEES

(30) Priorität: 01.03.2005 RU 2005105427
(43) Veröffentlichungstag der Anmeldung: 21.11.2007
(73) Patentinhaber: Samojlov, Valentin Nikolaevich, Dubna, Moskovskaya obl., 141980 (RU)
(72) Erfinder: DENISOV, Dmitrij Valerievich, St.Petersburg, 197373 (RU); KULIKOVSKIJ, Sergej Yurievich, St.Petersburg, 197373 (RU); SAMOSHKIN, Aleksandr Mihajlovich ul. Sosnovaya 5, Moskovskaya obl., 141980 (RU); SOKORIN, Oleg Naumovich, St.Petersburg, 190121 (RU)
(74) Vertreter: Jeck, Anton
(86) Internationale Anmeldenummer: PCT/RU2006/000034
(87) Internationale Veröffentlichungsnummer: WO 2006/093431

(56) Entgegenhaltungen:
- EP-A2- 0 337 783
- RU-C1- 2 064 177
- US-A- 5 189 366

## Beschreibung

Die Erfindung gehört zum Gebiet der Erforschung von Stoffen mittels Magnetfeldern und kann zur Feststellung und Identifizierung verschiedener Stoffe, und zwar von Psychopharmaka und Explosivstoffen, in stationären und mobilen Kontrollsystemen verwendet werden.

Bekannt ist eine Vorrichtung zur Feststellung von versteckten Stoffen gemäß der Literaturstelle [1] im beigefügten Literaturverzeichnis. Dieser Vorrichtung liegt eine Materialanalyse mittels Bestrahlung des Materials durch schnelle, monochromatische Neutronen und eine Bemessung eines dadurch ausgelösten Gammaspektrums zugrunde. Der Nachteil dieser Vorrichtung und dieses Verfahrens sind die Unmöglichkeit, Stoffe zu festzustellen, deren Atomrümpfe einen kleinen Einfangquerschnitt der schnellen Neutronen aufweisen, wobei eine erhebliche Strahlungsgefahr auftritt, die bei Verwendung dieser Vorrichtung besteht, und die Unmöglichkeit, sowohl die Struktur des Stoffs als auch die chemische Verbindung festzustellen.

Der vorliegenden Erfindung kommen auch eine Vorrichtung und ein Verfahren relativ nahe, die der Bestimmung der Natur und Eigenschaften von Stoffen mittels eines sich verändernden, elektromagnetischen Felds dient [2]. Dieses Verfahren basiert auf der Zuführung eines elektromagnetischen Signals zu einem Erreger- und Registrierungskreis in einem Messkreis eines induzierten Signals in An- und Abwesenheit eines untersuchten Objekts. Die Nachteile dieses Verfahrens und dieser Vorrichtung sind eine ungenügende Sensibilität und Trennschärfe bei der Feststellung und Identifizierung der Stoffe, wobei eine Erhöhung der Sensibilität und Trennschärfe beispielsweise eine unzulässig hohe Anzahl von Falschauslösungen der Kontrollsysteme und eine Beschädigung von Magnetplattenträgern in den kontrollierten Objekten hervorruft.

Die Aufgabe der vorliegenden Erfindung ist die Beseitigung der angeführten Mängel und die Erhöhung der Sensibilität und Trennschärfe bei der Feststellung und Identifizierung von Stoffen. Diese Aufgabe wird durch Folgendes gelöst: beim bekannten Verfahren, das die Anwendung des sich verändernden, elektromagnetischen Felds im Bereich der mutmaßlichen Existenz des gesuchten, versteckten Stoffs, die Bemessung der Antwort des angegebenen Felds auf Stoffe im angegebenen Bereich und den Vergleich der erhaltenen Antwort mit der vorgemessenen, kennzeichnenden Antwort für den gesuchten Stoff einschließt, wird gemäß der Erfindung die Information über charakteristische Raum-Frequenz-Merkmale des zu identifizierenden Stoffs gemessen und gespeichert; gemäß der Erfindung wird ferner auf Grund der angegebenen Information im angeführten Bereich eine lokale, nicht adiabatische Fluktuation des Vektorpotentials, die die Information über charakteristische Raum-Frequenz-Merkmale des gesuchten, versteckten Stoffs trägt, erzeugt und gespeichert; die Antwort des genannten Felds wird mittels Messung von Heterogenitätscharakteristiken bei der Polarisation der lokalen Feldfluktuation und Niederfrequenzüberlagerungen registriert, die durch Zusammenwirkung der angeführten Stoffe mit dem Feld ausgelöst werden; auf Grund des Vergleichs der gewonnenen Charakteristiken mit den Heterogenitätscharakteristiken für den gesuchten, versteckten Stoff wird eine Schlussfolgerung über das Vorhandensein dieses Stoffs unter den angeführten Stoffen gezogen; die angeführte, lokale Fluktuation des Vektorpotentials wird durch Übertragung einer modulierten Laserstrahlung, die die Information über charakteristische Raum-Frequenz-Merkmale des gesuchten, versteckten Stoffs trägt, über einen Übertragungslichtleiter gebildet, der über den angegebenen Bereich in Form einer Spule verläuft; die genannte Antwort wird anhand der Strahlung in einem Empfangslichtleiter registriert, der ebenso über den angegebenen Bereich in Form einer Spule verläuft. Es wird eine Vorrichtung zur Feststellung der versteckten Stoffe verwendet, die aus folgenden Teilen besteht:
- einem Block zur Auswahl und Speicherung der charakteristischen Merkmale des Stoffs, der aus Kondensator-platten besteht, die an eine Spannungsquelle und den Eingang eines Verstärkers, der Stromquelle, angeschlossen sind, dessen Ausgänge an einen Feldumformer angeschlossen sind; dabei ist der Eingang dieses Verstärkers mit einem Stromstabilisator verbunden, dessen Ausgang an die Stromeingänge von Hall-Elementen angeschlossen sind, die beispielsweise in einem Winkel von 90° zueinander bzw. von 45° zu einem Kraftvektor des vom angeführten Umformer gebildeten, elektromagnetischen Felds angeordnet werden; dabei sind die angeführten Hall-Elemente beispielsweise als Scheiben mit einer Anzahl der am Rande der angegebenen Scheiben platzierten Hall-Elektroden ausgeführt, deren Ausgänge mit den Eingängen eines Schalters verbunden sind, dessen Ausgang an einen Signalverstärker angeschlossen ist, der über zwei Ausgänge verfügt: der erste Ausgang ist mit dem Eingang einer aktiven Sperre, und der zweite Ausgang ist mit dem Schalter verbunden; dabei ist der Ausgang des angeführten, Hochpassfilters mit dem Eingang eines Analog-Digital-Wandlers verbunden, dessen Ausgang an den Eingang einer EDV1-Anlage angeschlossen ist, deren erster Ausgang mit dem Steuereingang des angeführten Schalters, deren zweiter Ausgang mit dem Steuereingang eines informationsschalters und dessen dritter Ausgang mit dem Eingang eines Speicherblocks verbunden ist; die Informationsschalterausgänge sind dabei an die Informationseingänge des angeführten Speicherblocks angeschlossen;
- einem Senderblock, der einen Speicherblock mit mittels des angeführten Blocks zur Aussonderung und Speicherung der charakteristischen Merkmale des Stoffs gepeicherten Signalen aus gewählten Richtungen enthält, wobei Ausgänge des Speicherblocks mit den Eingängen eines Summierers verbunden sind, der in Reihe mit einem Verstärker (Laserstrahlungsquelle) liegt; dieser Verstärker ist mit einer Sendeantenne verbunden, die einen auf ein beispielsweise zylinderförmiges Gerüst aufgewickelten Lichtleiter aufweist;
- einem Empfänger- und Umformer-Klassifikator-Block, der Folgendes umfasst: eine Empfangsspule in Form eines auf beispielsweise einem zylinderförmigen Gerüst aufgewickelten Lichtleiters, einen Verzweiger, eine Laserstrahlungsquelle, ein Stromstabilisator, dessen einen Fotoempfänger, ein Stromstabilisator, dessen Ausgang mit den Stromeingängen der Hall-Elemente verbunden ist, deren Ausgänge an die Eingänge des Schalters angeschlossen sind, dessen Ausgang in Reihe mit dem Verstärker liegt, eine aktive Niederfrequenzsperre, einen Analog-Digital-Wandler und eine EDV2-Anlage, deren Ausgang an die Steuereingänge des angeführten Schalters angeschlossen ist, und eine Stromquelle, die an einen MagnetfeldUmformer angeschlossen ist.

Das Verfahren gemäß der Erfindung beruht auf grundlegenden, physikalischen Prinzipien. Die Grundlage des Verfahrens ist die Zusammenwirkung des Stoffs mit dem Feld. Unter "Feld" ist nicht nur das elektrische Feld und das Magnetfeld gemeint, die getrennt oder zusammen anhand der Maxwellschen Gleichungen beschrieben werden können, sondern auch das Vektorpotential, dessen temporäre und räumliche Veränderung dieses elektromagnetische Feld erzeugt. Mit "Zusammenwirkung" ist nicht nur der Einfluss des Felds auf den Stoff, sondern auch der Einfluss des Stoffs auf das Feld gemeint. Nach der Entdeckung des Aharonov-Bohm-Effekts (Y. Aharonov and D. Bohm, Phys.Rev. 115(3), S. 485, 1959) und dessen Nachweis auf experimentellem Weg (R. Chambers, Phys. Rev. Lett., 5, S. 3, 1960, und A. Tonomura, Phys. Rev. Lett., 56, S. 792, 1986) wurde klar, dass das Vektorpotential - sei es auch wirbelfrei - anhand der Interferenzwirkungen auf das Quantenniveau registriert werden kann. Die Abwesenheit des elektromagnetischen Felds im Raum, der durch den untersuchten Stoff besetzt ist, bedeutet also nicht eine fehlende Zusammenwirkung des Stoffs mit dem Feld. Wenn in den vom Stoff besetzten Raum eine nicht adiabatische Störung (Fluktuation) entweder der Stoffstruktur oder des Vektorpotentials eingeführt wird, kann die Zusammenwirkung nachgewiesen werden.

Die Zusammenwirkung des Stoffs mit dem Feld besteht in der gegenseitigen Beeinflussung von Stoff und Feld. Wenn die Fluktuation des Felds im vom Stoff besetzten Raum stattfindet, wenn also das Vektorpotential auf irgendeine Weise lokal verändert wird, ruft diese Änderung in Raum und Zeit gemäß der Maxwell-Heaviside-Lorentz-Gleichung ein von Null abweichendes, elektromagnetisches Feld hervor. Auf diese Weise wird die lokale Veränderung der Energie- und der Kraftcharakteristiken des Raums herbeigeführt, in dem sich der Messstoff befindet. Indem der Stoff die Zusammenwirkung mit dem Feld eingeht, verändert er die lokalen Charakteristiken des Felds. Die Änderungen hängen dabei von der Stoffstruktur ab. Diese Änderungen im Skalar- sowie Vektorpotential verbreiten sich mit Lichtgeschwindigkeit in bestimmten Richtungen in zugeordneten Raumwinkeln. Die Anisotropie bei der Detektion ist durch mehrere Ursachen bedingt:

### 1. Reguläre Stoffstruktur.

Wenn die Stoffstruktur der kristallinen nahe kommt bzw. wenn Makromoleküle aus gut ausgewählten Richtungen auftreten, kann auch eine Anisotropie bei der Verbreitung der Fluktuationsantwort erwartet werden. Die Anisotropie der Spins von zusammenwirkenden Elektronen kann einen stärker ausgeprägten Charakter haben als die Anisotropie der Struktur auf Molekularniveau.

### 2. Vorhandensein von ausgewählten Richtungen (sinkende Symmetrie).

Unter realen Feststellbedingungen steht der Stoff unter dem Einfluss der Felder technogener Art. Außerdem wird das erdmagnetische Feld fast nicht abgeschirmt. Die Einführung einer kleinen Störung in den vom Stoff besetzten Raum verändert die potentielle Energie dieses Raums. Schließlich antwortet das offene System auf der eigenen Frequenz und kehrt zum thermodynamischen Gleichgewicht zurück, aus dem es gebracht wurde. Das Feldpotential verändert sich lokal an der Stelle der Fluktuation vom Potential der Struktur, die eigene Schwingungen erzeugt. Das Feldpotential verändert sich also synchron mit den Schwingungen der Stoffstruktur, d. h. trägt nicht nur die Frequenzcharakteristik, sondern auch die Phasencharakteristik des Stoffs.

Ein beliebiger Stoff, der aus dem thermodynamischen Gleichgewicht gebracht wurde, antwortet auf die Potentialfluktuation. Dabei ist es notwendig, dass die eigenen Frequenzen des Detektors spektral mit dem modulierten, vom Stoff erhaltenen Signal der Potentialfluktuation zusammenfallen. Wenn es nicht beachtet wird, kann das erhaltene Signal das gemessene sowohl verkleinern als auch vergrößern, je nach dem Phasenverhältnis der eingehenden Potentialfluktuation und Potentialfluktuation durch Störung der Detektorstruktur. Auch wenn diese Frequenzen nah genug sind, sind Nebenüberlagerungen möglich, d. h. Erzeugung von Frequenzen, die dem Stoff nicht eigen sind. Mit anderen Worten sollten zur Messzuverlässigkeit das Frequenzspektrum und die Anisotropie der Detektorantwort auf die Potentialfluktuation vor den Messungen bestimmt und tabelliert werden.

Zur Umsetzung des Verfahrens gemäß der Erfindung wird eine Vorrichtung zur Feststellung und Identifizierung der versteckten Stoffe vorgeschlagen.

In Fig. 1 ist das Wirkungsschema dieser Vorrichtung mit folgenden Bedeutungen dargestellt
- 0: der zu identifizierende Stoff,
- 1: Block zur Auswahl und Speicherung der charakteristischen Merkmale des Stoffs,
- 2: Senderblock,
- 3: Empfänger- und Umformer-Klassifikator-Block.

In Fig. 2 ist ein Schema des Blocks zur Auswahl und Speicherung der charakteristischen Merkmale des Stoffs mit folgenden Bedeutungen abgebildet:
- 4: Spannungsquelle,
- 5: Stromquelle,
- 6: Kondensator-platten,
- 7: Magnetfeldumformer,
- 8: Verstärker,
- 9: Stromstabilisator,
- 10: Magnetfeldumformer,
- 11: Stromquelle,
- 12: Hall-Element,
- 13: Hall-Element,
- 14: Schalter,
- 15: Verstärker,
- 16: Hochpassfilter
- 17: Analog-Digital-Wandler,
- 18: EDV1-Anlage,
- 19: Schalter,
- 20: Speicherblock.

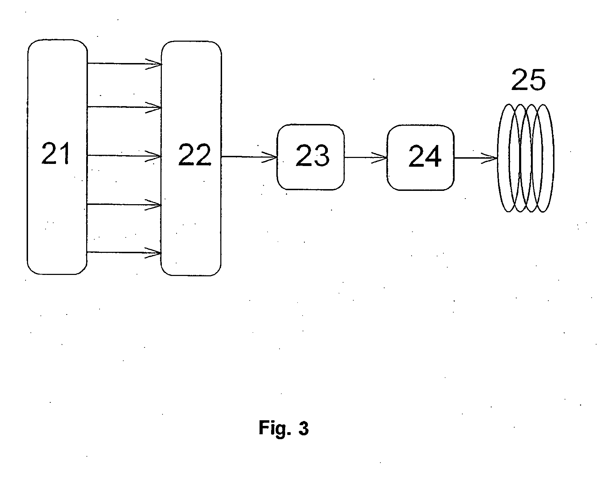

In Fig. 3 ist ein Schema des Senderblocks mit folgenden Bedeutungen abgebildet:
- 21: Speicherblock,
- 22: Summierer,
- 23: Verstärker,
- 24: Strahlungsquelle,
- 25: Sendeantenne.

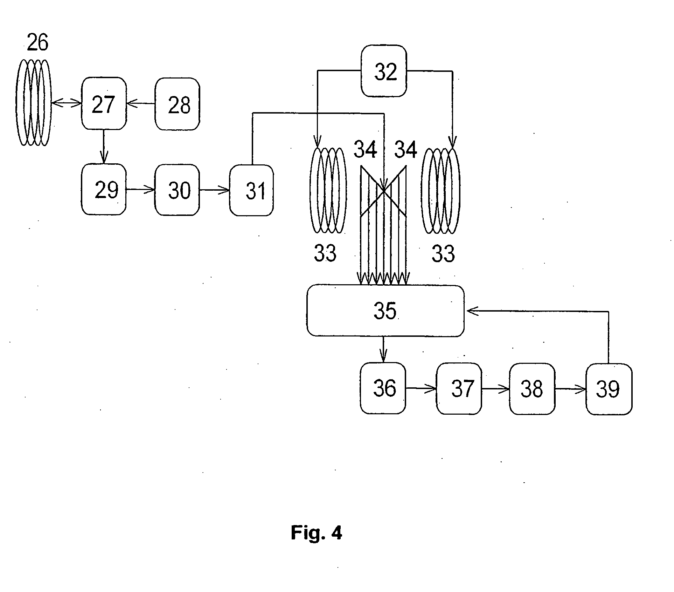

In Fig. 4 ist ein Schema des Empfänger- und Umformer-Klassifikator-Blocks mit folgenden Bedeutungen abgebildet:
- 26: Empfangsspule,
- 27: Verzweiger,
- 28: Strahlungsquelle,
- 29: Fotoempfänger,
- 30: Verstärker,
- 31: Stromstabilisator,
- 32: Stromquelle,
- 33: Magnetfeldumformer,
- 34: Ausgänge von Hall-Elementen,
- 35: Schalter,
- 36: Verstärker,
- 37: Hochpassfilter,
- 38: Analog-Digital-Wandler,
- 39: EDV2-Anlage.

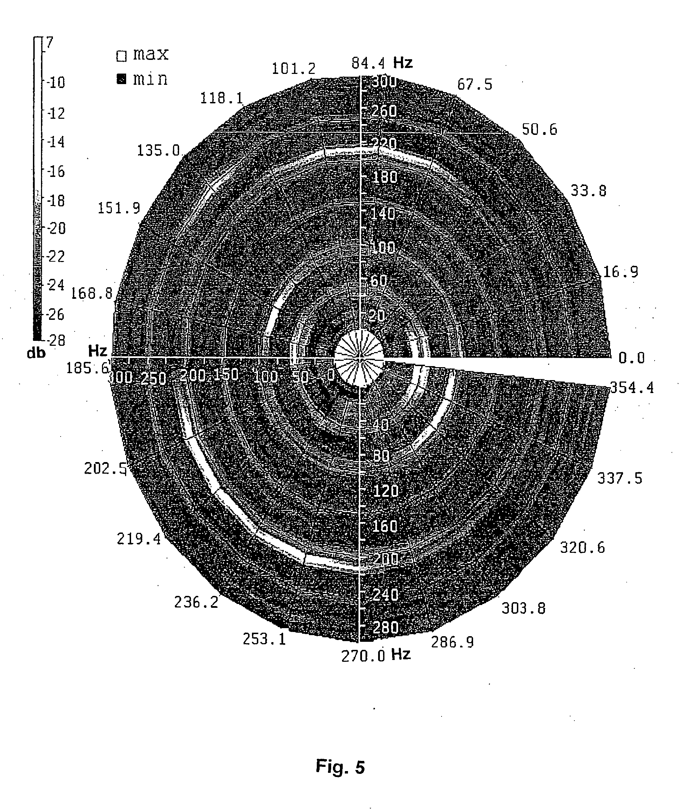

In Fig. 5 ist ein dreidimensionales Raum-Frequenz-Spektrum von Aspirin C abgebildet.

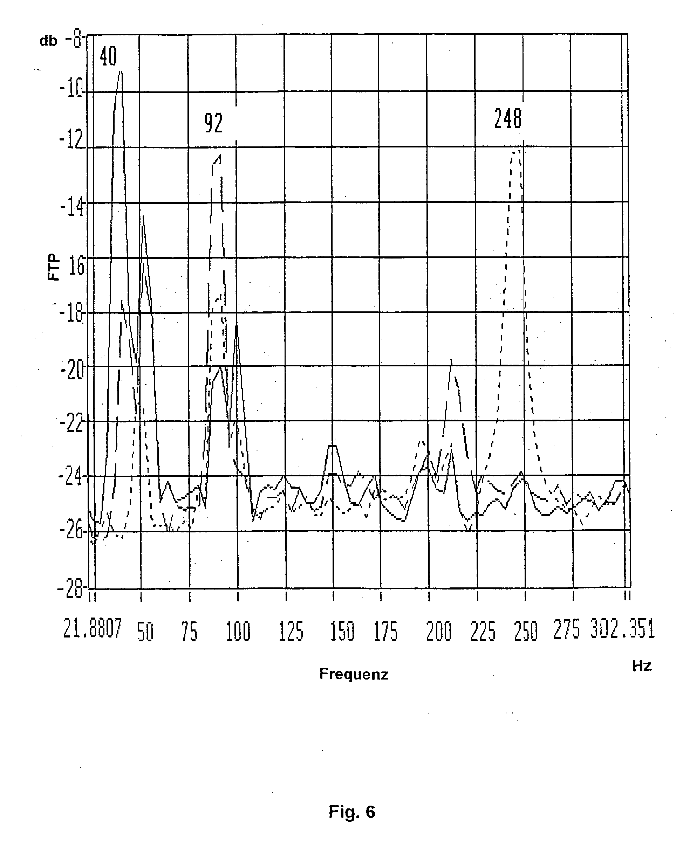

In Fig. 6 ist das mit der EDV-Anlage berechnete Fourier-Spektrum von Aspirin C für ausgewählte Winkel zu sehen, in denen die Höchstpunkte auf folgenden Frequenzen registriert wurden:

| | |
|---|---|
| 40 Hz (für Winkel 16,87°) | mit Volllinie bezeichnet, |
| 92 Hz (für Winkel 151,87°) | mit gestrichelter Linie bezeichnet, |
| 248 Hz (für Winkel 135°) | mit Punktlinie bezeichnet. |

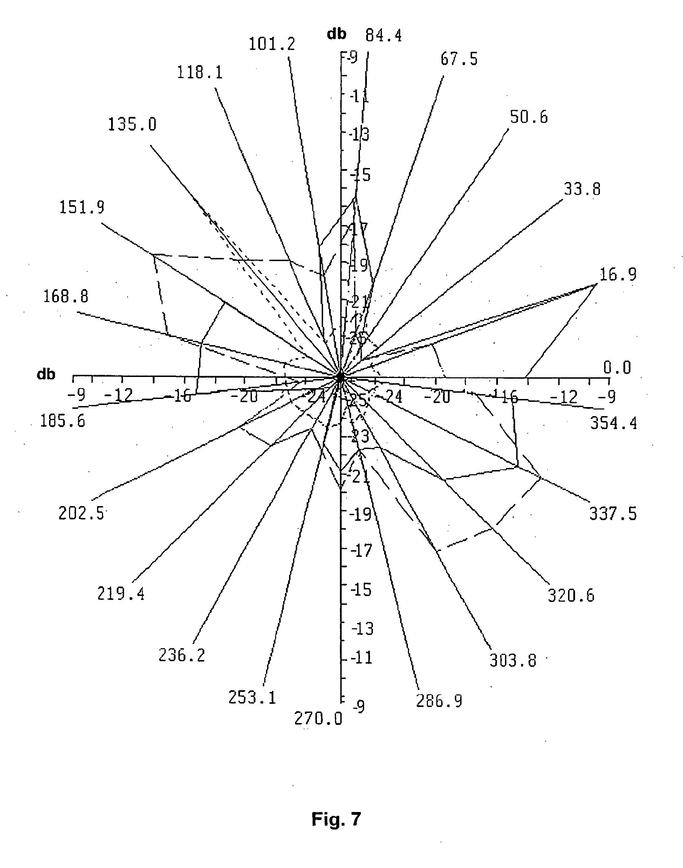

In Fig. 7 ist das Winkeldiagramm der Verteilung für das Fourier-Spektrum-Modul von Aspirin C auf folgenden Frequenzen dargestellt:

| | |
|---|---|
| 40 Hz | mit Volllinie bezeichnet, |
| 92 Hz | mit Strichlinie bezeichnet, |
| 248 Hz | mit Punktlinie bezeichnet. |

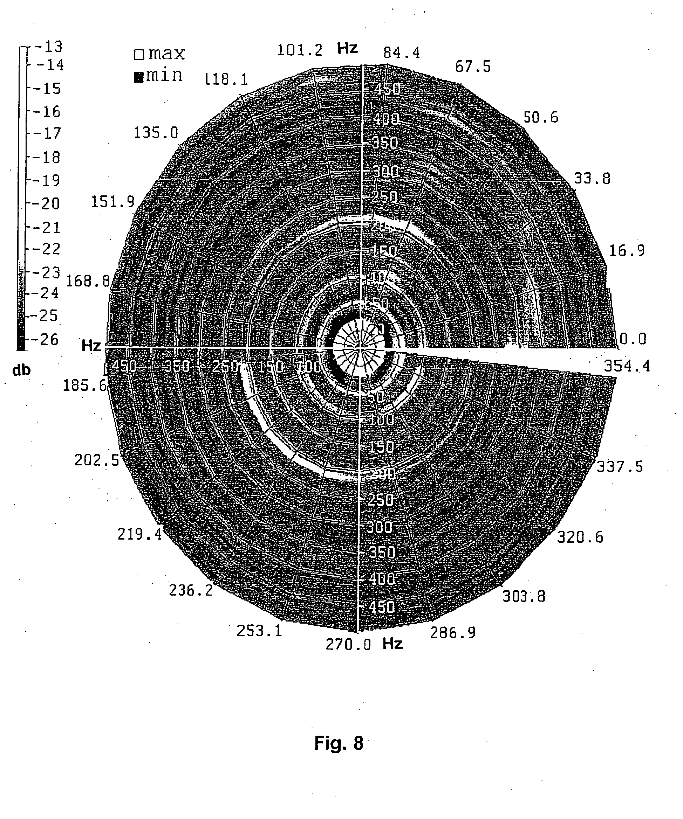

In Fig. 8 ist das dreidimensionale Raum-Frequenz-Spektrum eines Stoffgemisches aus Aspirin C, Wodka, Zucker und Kochsalz abgebildet.

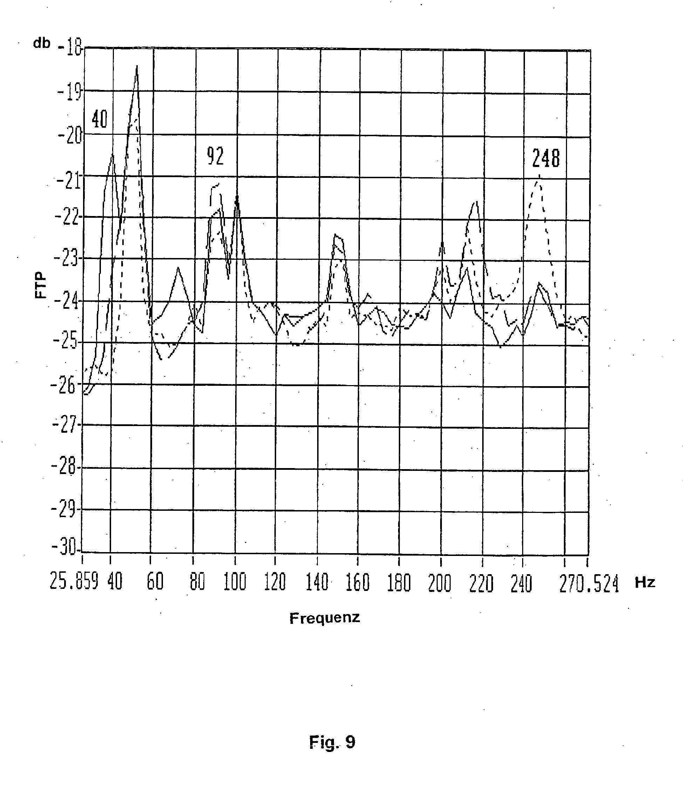

In Fig. 9 sind Fourier-Spektrum-Module des Signals des Gemisches der zu identifizierenden Stoffe in den für Aspirin C gewählten Winkeln dargestellt:

| | |
|---|---|
| 16,87° | mit Volllinie bezeichnet, |
| 151,87° | mit Strichlinie bezeichnet, |
| 135° | mit Punktlinie bezeichnet. |

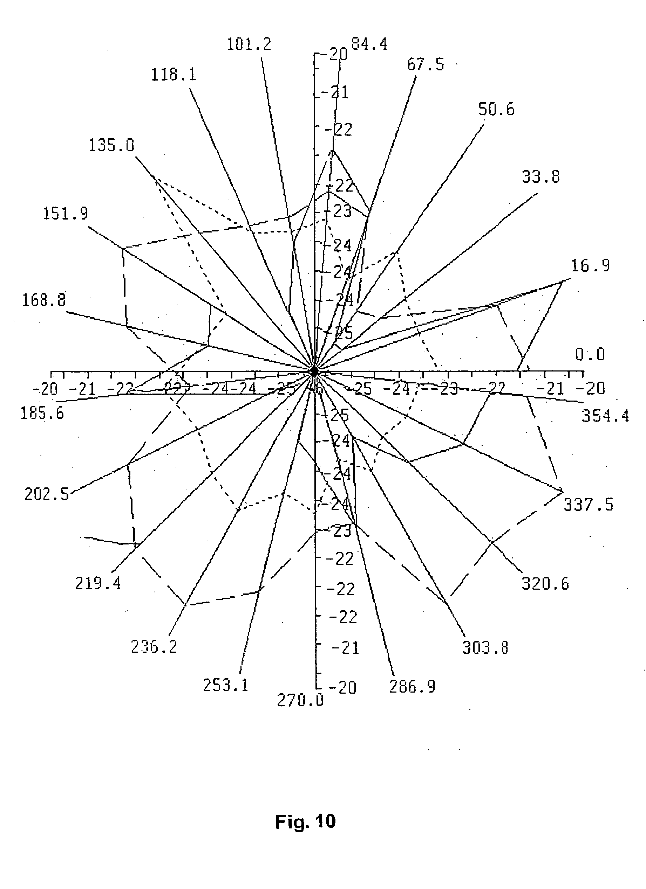

In Fig. 10 ist das Winkeldiagramm der Verteilung für das Fourier-Spektrum-Modul abgebildet, das vom Stoffgemisch (Aspirin C, Wodka, Zucker und Kochsalz) auf folgenden, für Aspirin C charakteristischen Frequenzen erhalten wurde:

| | |
|---|---|
| 40 Hz | mit Volllinie bezeichnet, |
| 92 Hz | mit Strichlinie bezeichnet, |
| 248 Hz | mit Punktlinie bezeichnet. |

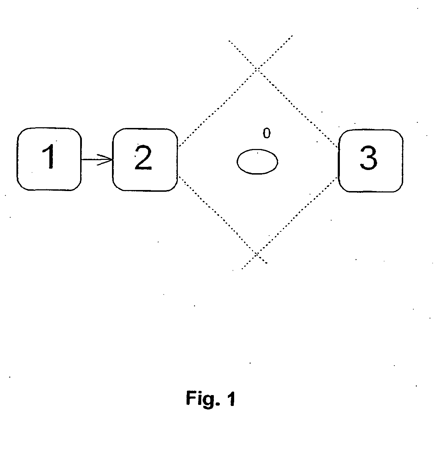

Das Verfahren gemäß der Erfindung wird mit Hilfe einer Vorrichtung gemäß der Erfindung (Fig.1) realisiert, das auf folgende Weise arbeitet.

Mit Hilfe des Blocks zur Auswahl und Speicherung der charakteristischen Merkmale des Stoffs 1 werden charakteristische Raum-Frequenz-Merkmale der zu identifizierenden Stoffe ausgewählt und gespeichert. Die Speicherzellen mit charakteristischen Merkmalen der Stoffe können weiter vervielfältigt und an den Sender 2 angeschlossen werden. Der Sender mit dem eingebauten Strahler löst in dem durch den zu identifizierenden Stoff besetzten Raum eine lokale Feldfluktuation mit dem vorgegebenen Satz der Eigenschaften aus. Der Stoff verändert beim Zusammenwirkung mit dem Feld lokal seine Charakteristiken. Dabei ist die Veränderung der Feldcharakteristiken mit Besonderheiten der Stoffstruktur verbunden. Falls der Stoff die Eigenschaften besitzt, die den ausgestrahlten ähnlich sind, bilden sich bei der Polarisation der lokalen Feldfluktuation Heterogenitäten und Niederfrequenzüberlagerungen, deren Raum-Frequenz-Charakteristiken vom Empfänger und Umformer-Klassifikator 3 registriert und identifiziert werden.

Aufgrund der erhaltenen Informationen wird eine Schlussfolgerung über das Vorhandensein des gesuchten Stoffs im Suchbereich gezogen.

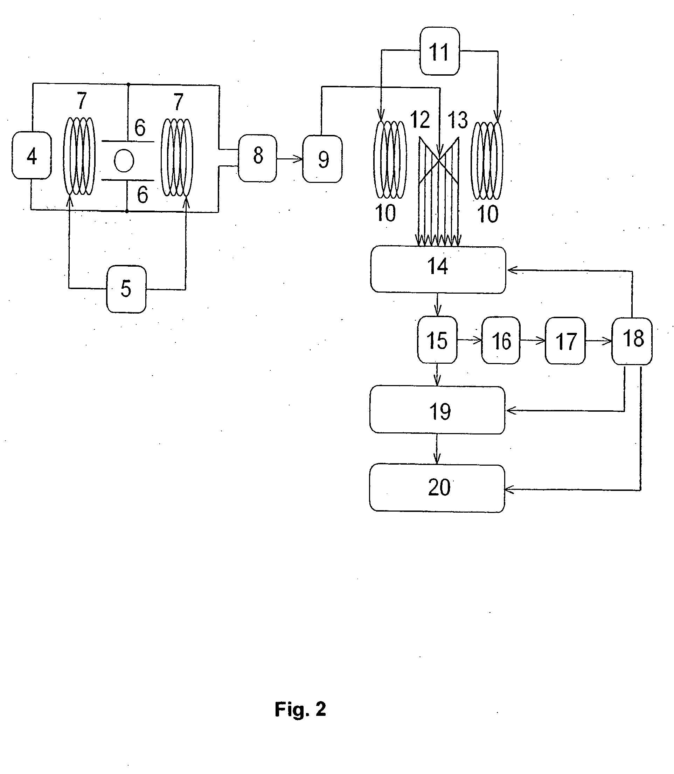

Der Block zur Auswahl und Speicherung der charakteristischen Merkmale des Stoffs (Fig. 2) arbeitet in folgender Weise.

Die Probe eines der Stoffe, der weiter identifiziert werden soll, wird zwischen den Kondensator-platten 6 positioniert, die durch die Spannungsquelle 4 unter eine Polarisierungsgleichspannung gesetzt werden. Die Stromquelle 5, deren erster Ausgang und zweiter Ausgang an den Magnetfeldumformer 7 angeschlossen sind, stellt den nötigen Wert des Magnetinduktionsvektors sicher, der senkrecht zum Vektor des von den Kondensator-platten 6 gebildeten, elektrischen Felds positioniert ist. Das Signal von den Kondensator-platten 6 wird vom Verstärker 8 verstärkt und zum Stromstabilisator 9 geleitet, der die Hall-Elemente 12 und 13 speist. Die Stromquelle 11, deren erster Ausgang und zweiter Ausgang an den Magnetfeldumformer 10 angeschlossen sind, stellt den nötigen Wert des Magnetinduktionsvektors im Raum sicher, in dem sich die in Form von Scheiben (oder anderen Layout-Formen) ausgeführten Hall-Elemente 12 und 13 und N befinden, wobei die Hall-Elektroden am Rande der Scheiben positioniert sind.

Von den Hall-Ausgängen wird mittels des durch die EDV1-Anlage 18 angesteuerten Schalters 14 die der Frequenzanalyse unterliegende Raumkoordinate des Signals Hochgewählt, die zur Reihenschaltung aus dem Verstärker 15, der aktiven Hochpassfilter 16, die zum Löschen des konstanten Signalbestandteils vorgesehen ist, dem Analog-Digital-Wandler 17 und der EDV1-Anlage 18 geleitet wird. Wenn der elektrische Strom das Hall-Element durchfließt, wird er vom Magnetfeld senkrecht zur Feld- und Stromrichtung abgelenkt und bildet auf diese Weise die Potentialdifferenz zwischen den seitlichen Elementbelägen. Eine wichtige Besonderheit ist, dass die den elektrischen Strom bildenden Elektronen eine unterschiedliche Geschwindigkeitsverteilung aufweisen. Obwohl der Strom durch das Hall-Element stabilisiert wird, bleibt die relative Geschwindigkeitsverteilung der Elektronen innerhalb ihres gesamten Stroms konstant und wird vom untersuchten Stoff bestimmt. Bei der Erzeugung des Konstantstroms ist die Geschwindigkeitsverteilung der Elektronen für alle Messungen gleich. Bei der Erregung des Stoffs ist der Strom, der ins Hall-Element fließt, Träger einzigartiger Eigenschaften dieses Stoffs, denn die Eigenschaften des Stroms sind von den Eigenschaften der Stoffprobe moduliert, einschließlich der Geschwindigkeitsverteilung der Elektronen. Wie bekannt ist, kann für die Geschwindigkeitsselektion der Elektronen ein Magnetfeld verwendet werden, das im Winkel zum elektrischen Feld ausgerichtet ist. Elektronen mit verschiedenen Geschwindigkeiten werden verschiedene Bahnen im homogenen Magnetfeld besitzen.

Diese Wirkung wird gerade in diesem Fall verwendet. Durch Umschaltung der räumlich voneinander entfernten Hall-Elektroden wird die wirksame Magnetfeldstärke verändert, wodurch die Geschwindigkeitsselektion der Elektronen in einem weiten Bereich und damit die Auswahl der charakteristischen Merkmale der untersuchten Stoffe ermöglicht werden.

Nach dem Hochpassfilter 16 bleibt nur der Bestandteil, der die Geschwindigkeitsverteilung der Elektronen und/oder die räumlich-temporäre Änderung des Vektorpotentials im Bereich des analysierten Stoffs charakterisiert. Je nach den Messbedingungen und Charakteristiken des getesteten Stoffs spielt gerade die Veränderung des Vektorpotentials die entscheidende Rolle bei der Analyse des elektromagnetischen Signals durch das Hall-Element. Nach dem Verlassen des Hochpassfilters 16 enthält das Signal eine einzigartige, räumliche Phasen-Frequenz-Charakteristik des gegebenen Stoffs. Erwähnenswert ist, dass bei dieser Analyse für zusammengesetzte Stoffe die Charakteristiken der Bestandteile verfolgt werden können. Mit einer spezialisierten Software wählt die EDV1-Anlage 18 aus einer Anzahl von Raumwinkeln, die den Aufstellungswinkeln der Hall-Elektroden entsprechen, diejenigen Winkel, in denen mittels der schnellen Fourier-Transformation (FFT) die für den Stoff 0 charakteristischen Höchst- oder Kleinstwerte des Fourier-Spektrum-Moduls bzw. beide registriert werden (Anzahl der FFT-Abzählungen und Höchst- bzw. Kleinstwerte werden je nach der Stoffzusammensetzung, dem erforderlichen Falschmeldungsniveau und anderen Parametern der Feststellqualität gewählt), und zwar derart, dass die Frequenz- und Winkelwerte für diesen Stoff 0 mit den Frequenz- und Winkelwerten für andere, zu identifizierende Stoffe nicht zusammenfallen.

Nach der Selektion der Winkel und diesen entsprechenden Frequenzen speichert die EDV1-Anlage 18 mit Hilfe der Schalter 14 und 19 und des Verstärkers 15 in der Speicherzelle 20 Signale aus den gewählten Richtungen, die für die zu identifizierenden Stoffe charakteristisch sind. Die Speicherzelle kann später vervielfältigt und im Empfangsteil anderer, ähnlicher Geräte montiert werden. Die Angaben über gewählte Richtungen und der diesen entsprechenden Fourier-Spektren werden für jeden der identifizierten Stoffe zur Verarbeitung der Messsignale zur EDV2-Anlage geleitet (Fig. 4, Pos. 39).

Der Senderblock (Fig. 3) arbeitet in folgender Weise.

Von den Ausgängen der Speicherzelle 21, in der die Signale aus den Richtungen registriert werden, die für die zu identifizierende Stoffe gewählt sind, werden die Signale mit Hilfe des "Blocks zur Auswahl und Speicherung der charakteristischen Merkmale des Stoffs" in Reihe zum Summierer 22, Verstärker 23, zur Strahlungsquelle 24 und Lichtleiter-Übergabespule 25 geleitet. Durch diese Konfiguration des Blocks ruft dieser mit Hilfe des zu ihm gehörenden Strahlers in dem durch den gesuchten Stoff besetzten Raum eine lokale Feldfluktuation mit dem in der Speicherzelle 21 vorhandenen Satz von Eigenschaften hervor.

Der Empfänger- und Umformer-Klassifikator-Block (Fig. 4) arbeitet in folgender Weise.

Das Signal wird als elektromagnetische Welle von der Empfangsantenne 26 durch den Verzweiger 27 auf die Fläche des Fotoempfängers 29 übergeben und in den Strom transformiert, der die Information über den Stoff enthält. Der Strom wird vom Verstärker 30 verstärkt und vom Strom-stabilisator 31 stabilisiert. Die Stromquelle 32, deren erster Ausgang und zweiter Ausgang an den Magnetfeldumformer 33 angeschlossen sind, stellt den nötigen Wert des Magnetinduktionsvektors im Raum sicher, in dem sich die in Form von Scheiben (oder anderen Layout-Formen) ausgeführten Hall-Sensoren 34 und N der am Rande der Scheiben positionierten Hall-Elektroden befinden. Von den Hall-Ausgängen wird mittels des durch die EDV2-Anlage 39 angesteuerten Schalters 35 die der Frequenzanalyse unterliegende Winkelkoordinate des Signals gewählt, die zur Reihenschaltung aus dem Verstärker 36, des Hochpassfilters 37, der zum Löschen des konstanten Signalbestandteils dient, dem Analog-Digital-Wandler 38 und der EDV2-Anlage 39 geleitet wird. Wenn der elektrische Strom das Hall-Element durchfließt, wird er vom Magnetfeld senkrecht zur Feld- und Stromrichtung abgelenkt, und er bildet auf diese Weise die Potentialdifferenz zwischen den seitlichen Elementbelägen. Eine wichtige Besonderheit ist, dass die den elektrischen Strom bildenden Elektronen eine unterschiedliche Geschwindigkeitsverteilung aufweisen.

Obwohl der Strom durch das Hall-Element stabilisiert wird, bleibt die relative Geschwindigkeitsverteilung der Elektronen innerhalb ihres gesamten Stroms konstant, und sie wird vom untersuchten Stoff bestimmt. Bei der Erzeugung des Konstantstroms ist die Geschwindigkeitsverteilung der Elektronen für alle Messungen gleich. Bei der Erregung des Stoffs ist der Strom, der ins Hall-Element fließt, Träger einzigartiger Eigenschaften dieses Stoffs, denn die Eigenschaften des Stroms sind durch die Eigenschaften der Stoffprobe moduliert, einschließlich der Geschwindigkeitsverteilung der Elektronen.

Wie bekannt ist, kann für die Geschwindigkeitsselektion der Elektronen ein Magnetfeld verwendet werden, das im Winkel zum elektrischen Feld ausgerichtet ist. Elektronen mit verschiedenen Geschwindigkeiten besitzen verschiedene Bahnen im homogenen Magnetfeld. Diese Wirkung wird gerade in diesem Fall benutzt. Durch Umschaltung der räumlich voneinander entfernten Hall-Elektroden wird die effektive Magnetfeldstärke verändert, wodurch die Geschwindigkeitsselektion der Elektronen in einem weiten Bereich und damit die Auswahl der charakteristischen Merkmale der untersuchten Stoffe ermöglicht werden. Nach der Sperre des Hochpassfilters 37 bleibt als Signal nur derjenige Bestandteil übrig, der die Geschwindigkeitsverteilung der Elektronen und/oder räumlich-temporäre Änderung des Vektorpotentials im Bereich des analysierten Stoffs charakterisiert. Nach dem Verlassen des Hochpassfilters 37 enthält das Signal eine einzigartige, räumliche Phasen-Frequenz-Charakteristik des gegebenen Stoffs, die für die Identifizierungsoperation durch die EDV2-Anlage 39 verwendet wird.

Erwähnenswert ist, dass bei einer solchen Analyse für zusammengesetzte Stoffe die Charakteristiken der Bestandteile verfolgt werden können.

### Beispiel für die Umsetzung des Verfahrens und der Vorrichtung gemäß der Erfindung

Als Beispiel wurde die Feststellung und Identifizierung von 50 g Aspirin C vorgenommen, wenn der genannte Stoff mit 50 g Zucker, 50 g Wodka und 50 g Kochsalz gemischt worden ist.

Gemäß der Erfindung wurde die genannte Menge Aspirin C zuerst zwischen den Kondensator-platten des Blocks zur Auswahl und Speicherung der charakteristischen Merkmale des Stoffs positioniert (Fig. 2).

Bei der Speicherung der charakteristischen Merkmale von Aspirin C wurde der absolute Wert registriert, der durch die schnelle Fourier-Transformation (FFT) des Signals erhalten wurde, das an den Kontakten der Hall-Elemente 34 bei einer Veränderung der Winkellagen von den Hall-Elementen gegen die gewählte Magnetfeldrichtung 7 abgefühlt wurde. Auf diese Weise wurden die Raum-Frequenz-Parameter der Molekülanordnung von Aspirin C registriert. Es waren insgesamt 22 Messrichtungen vorhanden, zwischen denen ein fester Winkel von 16,9° festgelegt war. Mittels der EDV-Anlage wurde das dreidimensionale Spektrum von Aspirin C (Fig. 5) gespeichert. Anhand des gewonnenen Spektrums wurden die für den gegebenen Stoff charakteristischen Richtungen der Winkellagen der Hall-Elemente (in diesem Fall 16,87°, 135° und 151,87°) gewählt, in denen die höchste Einengung der Winkellänge der Schwingungsresonanz beobachtet wurde. In den gewählten Winkeln wurde mittels der EDV-Anlage das Fourier-Spektrum (Fig. 6) ausgewählt, in dem die Höchstwerte, in diesem Fall auf den Frequenzen 40, 248 und 92 Hz, registriert wurden. Für diese Frequenzen wurde das Winkeldiagramm der Verteilung des Fourier-Modul-Spektrums für Aspirin C (Fig. 7) konstruiert. Im Winkeldiagramm heben sich drei Richtungen scharf ab: 16,87°, 151,87° und 135°, in denen die Resonanzen auf den Frequenzen 40, 92 und 248 Hz vorhanden sind. Gerade diese Kombination der Resonanzfrequenzen und ihren Winkelhöchstwerten bestimmt die Merkmale, anhand der die Identifizierung jedes Stoffs, in diesem Fall von Aspirin C, durchgeführt wird. Diese Informationen wurden in der Speicherzelle 21 gespeichert. In diesem Beispiel der Feststellung und Identifizierung von Aspirin C im Gemisch der genannten Stoffe wurden diese in einer Menge von je 50 g in einem Baumwollsack (Wodka in der Polyethylentüte) zwischen der Sendeantenne des Senderblocks und der Empfangsspule des Empfänger- und Umformer-Klassifikator-Blocks aufgehängt. Mit Hilfe der genannten Information in der Speicherzelle über die Raum-Frequenz-Merkmale von Aspirin C wurde mit dem Senderblock (Fig. 3) mittels Modulation der von der Strahlungsquelle 24 ausgestrahlten Laserstrahlung durch die genannte Information die diese Information tragende, lokale, nicht adiabatische Fluktuation des Vektorpotentials mit einer Frequenz von 1 Hz und einer Dauer von 0,1 s erzeugt und über die Sendeantenne 25 in denjenigen Raum gebracht, der das genannte Stoffgemisch enthält. Die Antwort auf die angeführte Fluktuation wurde vom Empfanger- und Umformer-Klassifikator-Block (Fig. 4) in Form von gemessenen Raum-Frequenz-Parametern des genannten Gemisches (s. Fig. 8) registriert. Um das Vorhandensein von Aspirin C im Gemisch nachzuweisen, enthielt diese Information die Fourier-Spektrum-Module für das Signal in den für Aspirin C gewählten Winkeln 16,87°, 151,87° und 135°; ferner wurden die Resonanzen auf den Frequenzen 40, 92 und 248 Hz (Fig. 9) erfasst. Anhand dieser Resonanzen wurde das Winkeldiagramm der Verteilung des Fourier-Spektrum-Moduls für das Signal des Gemisches der zu identifizierenden Stoffe auf den für Aspirin C gewählten Frequenzen (Fig. 10) konstruiert. Aus dem Vergleich der Figuren 6 und 7 mit den Figuren 9 und 10 ist ersichtlich, dass eine scharf ausgeprägte Übereinstimmung der gemessenen Winkelrichtungen von Resonanzen und ihren Frequenzen, die für das Signal des Gemisches registriert wurden, mit den Richtungen und Frequenzen der früher gespeicherten Probe besteht, die das Vorhandensein des gesuchten Stoffs (in diesem Fall von Aspirin C) nachweist. Die Schlussfolgerung über ein solches Vorhandensein wurde von der EDV2-Anlage gezogen. Die Feststellung und Identifizierung von Aspirin C bei kleineren Mengen davon im Gemisch wurden somit erfüllt. Die Mehrdeutigkeit in der Frage über ein Vorhandensein oder eine Abwesenheit von Aspirin C im genannten Stoffgemisch tritt nur bei der Verminderung der Stoffgemischmenge bis 1 g auf; dies zeugt von der hohen Wirksamkeit des Verfahrens und der Vorrichtung gemäß der Erfindung.

Auf ähnliche Weise wie Aspirin C wurde jeder der in diesem Gemisch enthaltene Stoff festgestellt und identifiziert.

## Patentansprüche

1. Verfahren zur Feststellung versteckter Stoffe, das das Zuführen eines sich verändernden Magnetfelds in den Raum der mutmaßlichen Existenz eines versteckten, gesuchten Stoffs, die Bemessung der Antwort des genannten Felds auf die Stoffe, die sich im angeführten Raum befinden, und einen Vergleich der erhaltenen Antwort mit einer früher gemessenen kennzeichnenden Antwort über einen gesuchten Stoff umfasst,
**dadurch gekennzeichnet, dass**
- zunächst Informationen über die charakteristischen Raum-Frequenz-Merkmale zu identifizierender Stoffe erfasst und gespeichert werden, wobei die charakteristischen Raum-Frequenz-Merkmale eines zu identifizierenden Stoffs die von dem jeweiligen einem sich verändernden elektromagnetischen Feld ausgesetzten Stoff bestimmte Geschwindigkeitsverteilung der Elektronen und/oder die räumlich-zeitliche Änderung des Vektorpotentials umfassen,
- anschließend mit Hilfe dieser Informationen im genannten Raum eine lokale, nicht adiabatische Fluktuation eines Vektorpotentials erzeugt wird, welche Fluktuation die Information über charakteristische Raum-Frequenz-Merkmale eines zu identifizierenden Stoffs trägt,
- dann eine Antwort des genannten Felds auf die Fluktuation gemessen wird und in der Antwort enthaltene Heterogenitätscharakteristiken in der Polarisation der lokalen Feldfluktuation und Niederfrequenzüberlagerungen identifiziert werden, die durch das Zusammenwirken der genannten Stoffe mit dem Feld hervorgerufen werden, und
- schließlich auf Grund des Vergleichs der gewonnenen Charakteristiken mit Charakteristiken für den gesuchten versteckten Stoff eine Schlussfolgerung über dessen Vorhandensein unter den gegebenen Stoffen gezogen wird.

2. Verfahren nach Anspruch 1,
**dadurch gekennzeichnet,**
**dass** die lokale Feldfluktuation des Vektorpotentials durch Transmission einer modulierten, die Information über charakteristische Raum-Frequenz-Merkmale des gesuchten versteckten Stoffs tragenden Laserstrahlung über einen Übertragungslichtleiter gebildet wird, der über den angegebenen Raum in Form einer Spule verläuft, und dass die angeführte Antwort anhand der Strahlung im Empfangslichtleiter gemessen wird, der ebenso über den angegebenen Raum in Form einer Spule verläuft.

3. Vorrichtung zur Durchführung eines Verfahrens nach Anspruch 1 oder 2,
**gekennzeichnet durch**
- einen Block (1) zur Auswahl und Speicherung der charakteristischen Merkmale des Stoffs (0), wobei der Block (1) Kondensatorplatten (6) aufweist, wobei:
- die Kondensatorplatten (6) an eine Spannungsquelle (4) und den Eingang eines Verstärkers (8) der angeschlossen sind,
- eine Stromquelle (5), deren Ausgänge an einen Feldumformer (7, 10) angeschlossen sind,
- der Ausgang des Verstärkers (8) mit einem Stromstabilisator (9) verbunden ist,
- der Ausgang des Stromstabilisators (9) an die Stromeingänge von Hall-Elementen (12, 13) angeschlossen ist, die vorzugsweise in einem Winkel von 90° zueinander bzw. von 45° zum Magnetfeldvektor des vom Feldumformer (7, 10) gebildeten, elektromagnetischen Felds angeordnet sind,
- die Hall-Elemente (12, 13) vorzugsweise als Scheiben mit einer Anzahl von am Rande der Scheiben platzierten Hall-Elektroden ausgebildet sind,
- die Ausgänge der Hall-Elektroden mit den Eingängen eines Schalters (14) verbunden sind,
- der Ausgang des Schalters (14) an einen Signalverstärker (15) angeschlossen ist, der über zwei Ausgänge verfügt, wobei der erste Ausgang mit dem Eingang eines Hochpassfilters (16) und der zweite Ausgang mit dem Schalter (14) verbunden ist,
- der Ausgang des Hochpassfilters (16) mit dem Eingang eines Analog-Digital-Wandlers (17) verbunden ist,
- der Ausgang dieses Wandlers (17) an den Eingang einer EDV1-Anlage (18) angeschlossen ist,
- die EDV1-Anlage(18) mit ihrem ersten Ausgang an den Steuereingang des Schalters (14), ihrem zweiten Ausgang an den Steuereingang des Informationsschalters (19) und mit ihrem dritten Ausgang an den Eingang des Speicherblocks (20) angeschlossen ist,
- die Informationsschalterausgänge mit den Informations- eingängen des Speicherblocks (20) verbunden sind,
- einen Senderblock (2), der einen Speicherblock (21) mit den mittels des Blocks(1) zur Auswahl und Speicherung der charakteristischen Merkmale des Stoffs (0) gespeicherten Signalen aus den gewählten Richtungen enthält, wobei:
- die Ausgänge dieses Senderblocks (2) mit den Eingängen eines Summierers (22) verbunden sind, der in Reihe mit einem Verstärker (23) und einer Laserstrahlungsquelle (24) liegt,
- die Laserstrahlungsquelle (24) mit einer Sendeantenne (25) verbunden ist, die einen vorzugsweise auf einem zylinderförmigen Gerüst aufgewickelten Lichtleiter aufweist,
- einen Empfänger- und Umformer-Klassifikator-Block (3), der aus einer Empfangsspule(26) in Form eines vorzugsweise auf ein zylinderförmiges Gerüst aufgewickelten Lichtleiters, aus einem Verzweiger (27), einer Laserstrahlungsquelle (28), einem Fotoempfänger (29 und einem Stromstabilisator (31) besteht, wobei:
- der Ausgang dieses Stromstabilisators (31) mit den Stromeingängen der Hall-Elemente (12, 13) verbunden ist,
- eine Anzahl von Ausgängen (34) der Hall-Elemente (12, 13) an die Eingänge eines Schalters (35) angeschlossen sind, dessen Ausgang in Reihe mit einem Verstärker (36), einem Hochpassfilter (37), einem Analog-Digital-Wandler(38) und einer EDV2-Anlage (39) liegt,
- der Ausgang der EDV2-Anlage an die Steuereingänge des genannten Schalters (35) angeschlossen ist, und
eine Stromquelle (5, 11, 32) vorgesehen ist, die mit einem Magnetfeld-Umformer (7, 10, 33) verbunden ist.

## Claims

1. A method for detecting concealed substances, which includes delivering a varying magnetic field into the space where a concealed substance being searched for is suspected to exist, measuring the response of said field to the substances that are located in said space, and comparing the response obtained to a definitive response, measured beforehand, about a substance being searched for,
**characterized in that**
- first, information about the characteristic space-frequency features of substances to be identified is acquired and stored in memory, and the characteristic space-frequency features of a substance to be identified include the speed distribution of the electrons, as determined by the particular substance exposed to a varying electromagnetic field, and/or the spatial-chronological variation in the vector potential;
- next, with the aid ofthis information, in said space, a local, non-adiabatic fluctuation of a vector potential is generated, which fluctuation carries the information about characteristic space-frequency features of a substance to be identified;
- then, a response of said field to the fluctuation is measured, and heterogeneity characteristics in the polarization of the local field fluctuation, which are contained in the response, and low-frequency superpositions are identified, which characteristics and superpositions are engendered by the interaction of said substances with the field; and
- finally, on the basis of the comparison of the characteristics obtained with characteristics for the concealed substance being searched for, a conclusion is drawn as to whether the substance being searched for is among the substances present.

2. The method of claim 1,
**characterized in that**
by transmission of a modulated laser radiation carrying the information about characteristic space-frequency features of the concealed substance being searched for, the local field fluctuation of the vector potential is formed via a transmitting optical waveguide, which extends across said space in the form of a coil; and that said response is measured on the basis of the radiation in the receiving optical waveguide, which likewise extends across said space in the form of a coil.

3. An apparatus for performing a method of claim 1 or 2,
**characterized by**
- a block (1) for selecting and storing the characteristic features of the substance (0), the block (1) having condenser plates (6);
- the condenser plates (6) are connected to a voltage source (4) and the input of an amplifier (8);
- a current source (5), whose outputs are connected to a field transformer (7, 10);
- the output of the amplifier (8) communicates with a current stabilizer (9);
- the output of the current stabilizer (9) is connected to the current inputs of Hall elements (12, 13), which are preferably embodied at an angle of 90° to one another or 45° from the magnetic field vector of the electromagnetic field formed by the field transformer (7, 10);
- the Hall elements (12, 13) are preferably embodied as disks having a number of Hall electrodes placed at the edge of the disks;
- the outputs of the Hall electrodes communicate with the inputs of a switch (14);
- the output of the switch (14) is connected to a signal amplifier (15), which has two outputs, of which the first output communicates with the input of a high-pass filter (16) and the second output communicates with the switch (14);
- the output of the high-pass filter (16) communicates with the input of an analog/digital converter (17);
- the output of this converter (17) is connected to the input of an EDV system (18);
- the EDV system (18) is connected by its first output to the control input of the switch (14), by its second output to the control input of the information switch (19), and by its third output to the input of the memory block (20);
- the information switch outputs communicate with the information inputs of the memory block (20);
- a transmitter block (2), which contains a memory block (21) having the signals from the selected directions, which signals have been stored in memory by means of the block (1) for selecting and storing the characteristic features of the substance (0); and
- the outputs of this transmitter block (2) communicate with the inputs of an adder (22) which is connected in series with an amplifier (23) and a laser radiation source (24);
- the laser radiation source (24) communicates with a transmitting antenna (25), which has an optical waveguide preferably wound onto a cylindrical framework;
- a receiver and transformer classifier block (3), which comprises a reception coil (26) in the form of an optical waveguide preferably wound onto a cylindrical framework, a branching point (27), a laser radiation source (28), a photoreceiver (29), and a current stabilizer (31), in which:
- the output of this current stabilizer (31) communicates with the current inputs of the Hall elements (12, 13);
- a number of outputs (34) of the Hall elements (12, 13) are connected to the inputs of a switch (35) whose output is connected in series with an amplifier (36), a high-pass filter (37), an analog/digital converter (38), and an EDV2 system (39);
- the output of the EDV2 system is connected to the control inputs of said switch (35); and
a current source (5, 11, 32) is provided, which communicates with a magnetic field transformer (7, 10, 33).

## Revendications

1. Procédé de détection de substances cachées, lequel comprend l'amenée d'un champ magnétique variable dans l'espace de l'existence supposée d'une substance cachée recherchée, la mesure de la réponse dudit champ aux substances qui se trouvent dans ledit espace et une comparaison de la réponse reçue avec une réponse caractéristique mesurée précédemment à une substance recherchée, **caractérisé en ce que**
- des informations sur les propriétés spatio-fréquentielles caractéristiques des substances à identifier sont d'abord saisies et mémorisées, les propriétés spatio-fréquentielles caractéristiques d'une substance à identifier comprenant la distribution des vitesses déterminée des électrons de la substance respective exposée à un champ magnétique variable et/ou la variation spatio-temporelle du potentiel vecteur,
- une fluctuation locale non adiabatique d'un potentiel vecteur est ensuite produite dans ledit espace à l'aide de ces informations, laquelle fluctuation porte l'information sur les propriétés spatio-fréquentielles caractéristiques d'une substance à identifier,
- une réponse dudit champ à la fluctuation est ensuite mesurée et des caractéristiques d'hétérogénéité dans la polarisation de la fluctuation locale de champ et des interférences basse fréquence contenues dans la réponse, qui sont provoquées par l'interaction desdites substances avec le champ, sont identifiées, et
- enfin, sur la base de la comparaison des caractéristiques obtenues avec des caractéristiques de la substance cachée recherchée, une conclusion est tirée sur la présence de celle-ci parmi les substances données.

2. Procédé selon la revendication 1,
**caractérisé en ce**
**que** la fluctuation locale de champ du potentiel vecteur est formée par transmission d'un rayonnement laser modulé, portant l'information sur les propriétés spatio-fréquentielles caractéristiques de la substance cachée recherchée sur un guide de lumière de transmission qui s'étend sur ledit espace sous la forme d'une bobine, et que ladite réponse est mesurée à l'aide du rayonnement dans le guide de lumière de réception qui s'étend également sur ledit espace sous la forme d'une bobine.

3. Dispositif pour réaliser le procédé selon la revendication 1 ou 2,
**caractérisé par**
- un bloc (1) pour sélectionner et mémoriser les propriétés caractéristiques de la substance (0), le bloc (1) présentant des plaques de condensateur (6), sachant que :
- les plaques de condensateur (6) sont connectées à une source de tension (4) et à l'entrée d'un amplificateur (8),
- une source de courant (5) dont les sorties sont connectées à un convertisseur de champ (7, 10),
- la sortie de l'amplificateur (8) est reliée à un stabilisateur de courant (9)
- la sortie du stabilisateur de courant (9) est connectée aux entrées de courant d'éléments de Hall (12, 13) qui sont de préférence disposés à un angle de 90° l'un par rapport à l'autre ou de 45° par rapport au vecteur de champ magnétique du champ électromagnétique formé par le convertisseur de champ (7, 10),
- les éléments de Hall (12, 13) sont de préférence réalisés sous la forme de disques avec un certain nombre d'électrodes de Hall placées au bord des disques,
- les sorties des électrodes de Hall sont reliées aux entrées d'un commutateur (14),
- la sortie du commutateur (14) est connectée à un amplificateur de signaux (15) qui dispose de deux sorties, la première sortie étant reliée à l'entrée d'un filtre passe-haut (16) et la deuxième sortie au commutateur (14),
- la sortie du filtre passe-haut (16) est reliée à l'entrée d'un convertisseur analogique-numérique (17),
- la sortie de ce convertisseur (17) est connectée à l'entrée d'un système informatique EDV 1 (18),
- le système informatique EDV1 (18) est connecté par sa première sortie à l'entrée de commande du commutateur (14), par sa deuxième sortie à l'entrée de commande du commutateur d'information (19) et par sa troisième sortie à l'entrée du bloc de mémoire (20),
- les sorties du commutateur d'information sont reliées aux entrées d'information du bloc de mémoire (20),
- un bloc émetteur (2) est prévu, qui contient un bloc de mémoire (21) avec les signaux des directions choisies mémorisés au moyen du bloc (1) pour sélectionner et mémoriser les propriétés caractéristiques de la substance (0),
- les sorties de ce bloc émetteur (2) sont reliées aux entrées d'un sommateur (22) qui est en série avec un amplificateur (23) et une source de rayonnement laser (24),
- la source de rayonnement laser (24) est reliée à une antenne d'émission (25) qui présente un guide de lumière enroulé de préférence sur un bâti cylindrique,
- un bloc classificateur récepteur et convertisseur (3) qui se compose d'une bobine de réception (26) sous la forme d'un guide de lumière enroulé de préférence sur un bâti cylindrique, d'un coupleur (27), d'une source de rayonnement laser (28), d'un photorécepteur (29) et d'un stabilisateur de courant (31), sachant que :
- la sortie de ce stabilisateur de courant (31) est reliée aux entrées de courant des éléments de Hall (12, 13),
- un certain nombre de sorties (34) des éléments de Hall (12, 13) sont connectées aux entrées d'un commutateur (35) dont la sortie est en série avec un amplificateur (36), un filtre passe-haut (37), un convertisseur analogique-numérique (38) et un système informatique EDV2 (39),
- la sortie du système informatique (EDV2) (39) est connectée aux entrées de commande dudit commutateur (35), et
une source de courant (5, 11, 32) est prévue, qui est reliée à un convertisseur de champ magnétique (7, 10, 33).
